# EUROPÄISCHE PATENTANMELDUNG

(11) **EP 0 814 341 A2**
(43) Veröffentlichungstag der Anmeldung: **29.12.1997**
(21) Anmeldenummer: 97109102.0
(22) Anmeldetag: 05.06.1997
(51) Int. Cl.: G01R 19/04

(54) **Schaltungsanordnung zur Bildung eines der Amplitude eines Eingangssignals entsprechenden Ausgangssignals**

(30) Priorität: 19.06.1996 DE 19624391
(71) Anmelder: TEMIC TELEFUNKEN microelectronic GmbH, 74072 Heilbronn (DE)
(72) Erfinder: Häfner, Horst, 74080 Heilbronn (DE); Hammel, Hermann, 74585 Rot am See (DE); Schmidt, Friedemann, 71679 Asperg (DE); Schnabel, Jürgen, 74211 Leingarten (DE)
(74) Vertreter: Maute, Hans-Jürgen, Dipl.-Ing.

(57) **Zusammenfassung**

Beschrieben wird eine Schaltungsanordnung zur Bildung eines der Amplitude eines Eingangssignals entsprechenden Ausgangssignals. Zur Verstärkung des Eingangssignals ist eine Verstärkerkette aus mehreren in Reihe geschalteten temperaturkompensierten Verstärkerstufen vorgesehen, die jeweils einen Meßausgang aufweisen, an dem ein der Aussteuerung der jeweiligen Verstärkerstufe entsprechendes Meßsignal ansteht. Eine mit den Meßausgängen der Verstärkerstufen verbundene Summationseinheit erzeugt durch Summation der Meßsignale ein im wesentlichen durch die Anzahl der übersteuerten Verstärkerstufen bestimmtes Summensignal, das an einem Summationsausgang der Summationseinheit als Ausgangssignal ansteht.

## Beschreibung

Die Erfindung betrifft eine Schaltungsanordnung zur Bildung eines der Amplitude eines Eingangssignals entsprechenden Ausgangssignals.

Eine derartige Schaltungsanordnung ist aus Tietze, Schenk: 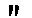 Halbleiter-Schaltungstechnik", Springer-Verlag, 1978, Seite 662 - 663 bekannt. Die dort beschriebene Schaltungsanordnung weist einen ersten Spannungsfolger, dem das Eingangssignal zugeführt wird, einen zweiten Spannungsfolger, der das Ausgangssignal liefert, eine Diode, einen Vorwiderstand, einen Kondensator und einen Schalter auf. Der Eingang des zweiten Spannungsfolgers ist über die Diode und den zu dieser in Reihe geschalteten Vorwiderstand mit dem Ausgang des ersten Spannungsfolgers und über den Kondensator und den dazu parallel geschalteten Schalter mit Masse verbunden.

Zur Bildung des der Amplitude des Eingangssignals entsprechenden Ausgangssignals, d. h. zur Messung der Amplitude des Eingangssignals, wird zunächst der Schalter geöffnet. Der Kondensator wird somit bei steigender Amplitude des Eingangssignals über die Diode und den Vorwiderstand auf eine dem momentanen Wert des Eingangssignals entsprechende Ladung aufgeladen. Bei fallender Amplitude des Eingangssignals bleibt die Ladung des Kondensators hingegen erhalten, da die Diode eine Entladung des Kondensators über den ersten Spannungsfolger verhindert und da der zweite Spannungsfolger den Kondensator nicht belastet. Die Ladung des Kondensators ist demnach ein Maß der Amplitude des Eingangssignals, so daß der zweite Spannungsfolger als Meßergebnis das der Amplitude des Eingangssignals entsprechende Ausgangssignal liefert. Über den Schalter läßt sich der Kondensator anschließend für eine neue Messung entladen.

Der wesentliche Nachteil der Schaltungsanordnung besteht darin, daß der Kondensator nur verzögert, d. h. asymptotisch, auf die dem momentanen wert des Eingangssignals entsprechende Ladung aufgeladen wird und daß die Messung demzufolge mit zunehmender Frequenz des Eingangssignals ungenauer wird. Ursache dieser Verzögerung ist der Spannungsabfall am Vorwiderstand, welcher zur Reduzierung der Schwingungsneigung der Schaltungsanordnung zwischen den ersten Spannungsfolger und den Kondensator geschaltet ist. Des weiteren lassen sich mit der Schaltungsanordnung keine kontinuierlichen Messungen durchführen, da der Kondensator für jede Messung über den Schalter entladen werden muß. Durch Schaltvorgänge bedingte Störungen können dabei Meßfehler verursachen. Außerdem beansprucht der Kondensator bei der Integration der Schaltungsanordnung in einen integrierten Schaltkreis erhebliche Chipfläche.

Der Erfindung liegt die Aufgabe zugrunde, eine vorteilhafte Schaltungsanordnung gemäß dem Oberbegriff des Patentanspruchs 1 anzugeben, die mit geringem Schaltungsaufwand kostengünstig in einen integrierten Schaltkreis integrierbar ist, die ungetaktet betrieben wird, die genaue Meßergebnisse liefert und die insbesondere zur Messung der Amplitude von hochfrequenten Eingangssignalen einsetzbar ist.

Die Aufgabe wird erfindungsgemäß durch die kennzeichnenden Merkmale des Patentanspruchs 1 gelöst. Vorteilhafte Ausgestaltungen und Weiterbildungen ergeben sich aus den Unteransprüchen.

Die Verstärkerstufen der erfindungsgemäßen Schaltungsanordnung sind als temperaturkompensierte Verstärker, d. h. als Verstärker mit von der Temperatur der Verstärkerstufen unabhängigen, vorzugsweise gleichen Verstärkungsfaktoren ausgebildet. Sie sind als Verstärkerkette beschaltet, d. h. sie sind in Reihe hintereinander geschaltet, wobei ein Verstärkereingang einer nachgeschalteten Verstärkerstufe mit einem Verstärkerausgang der vorherigen Verstärkerstufe verbunden ist. Die Verstärkerstufen können in Abhängigkeit der Amplitude des Eingangssignals übersteuert, d. h. gesättigt werden. Eine verstärkerstufe ist dabei dann übersteuert oder gesättigt, wenn ein ihrem Verstärkereingang zugeführtes Signal eine Aussteuergrenze der Verstärkerstufe überschreitet, so daß eine verzerrungsfreie Verstärkung nicht mehr möglich ist. Die Verstärkerstufen weisen jeweils einen Meßausgang auf, an dem ein der Aussteuerung der jeweiligen Verstärkerstufe entsprechendes Meßsignal ansteht. Eine mit den Meßausgängen der Verstärkerstufen verbundene Summationseinheit erzeugt durch Summation der Meßsignale ein Summensignal, das als Ausgangssignal an einem Summationsausgang der Summationseinheit ansteht. Das Summensignal wird im wesentlichen durch die Anzahl der übersteuerten, d. h. gesättigten, Verstärkerstufen bestimmt und ist demzufolge ein Maß der Amplitude des Eingangssignals. Es ist bei Verstärkerstufen mit jeweils gleichen Verstärkungsfaktoren in etwa proportional zum Logarithmus der Amplitude des Eingangssignals.

Da die Verstärkerstufen temperaturkompensiert sind, sind ihre Verstärkungsfaktoren temperaturunabhängig, so daß bei gleicher Amplitude des Eingangssignal immer die gleiche Anzahl von Verstärkerstufen übersteuert sind. Die Schaltungsanordnung ist zur Durchführung von kontinuierlichen Messungen geeignet. Sie weist aufgrund fehlender Rückkopplung in der verstärkerkette eine geringe Schwingungsneigung auf, so daß sie sich auch zur Amplitudenmessung von hochfrequenten Eingangssignalen eignet.

Die Verstärkerstufen weisen vorzugsweise jeweils zwei bipolare Verstärkertransistoren in Differenzverstärkerschaltung, jeweils eine mit den Emitteranschlüssen der Verstärkertransistoren verbundene Emitterstromquelle, die einen zur Temperatur der Verstärkerstufen proportionalen Querstrom liefert, und jeweils eine durch die Emitteranschlüsse der Verstärkertransistoren steuerbare Ausgangsstromquelle auf, welche vorteilhafterweise als bipolarer Ausgangstransistor ausgebildet ist und am Meßausgang einen Meßstrom als Meßsignal liefert. Die Verstärkereingänge und die Verstärkerausgänge der Verstärkerstufen sind dabei als differentielle Eingangsanschlüsse bzw. als differentielle Ausgangsanschlüsse ausgebildet, wobei die Basisanschlüsse bzw. die Kollektoranschlüsse der Verstärkertransistoren einer Verstärkerstufe jeweils mit einem der differentiellen Eingangsanschlüsse bzw. Ausgangsanschlüsse dieser Verstärkerstufe verbunden sind.

Die Summationseinheit erzeugt aus den Meßströmen vorzugsweise durch Summation und anschließende Tiefpaßfilterung das Summensignal, welches beispielsweise als Summationsstrom aus einem Summationsausgang der Summationseinheit zur weiteren Verarbeitung oder Auswertung auskoppelbar ist.

Die Schaltungsanordnung weist einen großen Dynamikbereich auf, d. h. es sind sowohl sehr geringe Amplituden als auch große Amplituden meßbar, so daß sie bestens zur Messung der Feldstärke eines Funksignals geeignet ist.

Die Erfindung wird im folgenden anhand der Figuren näher beschrieben. Es zeigen:
- Figur 1: ein Prinzipschaltbild der erfindungsgemäßen Schaltungsanordnung und
- Figur 2a und 2b: ein Ausführungsbeispiel der Schaltungsanordnung aus Figur 1 mit einer Auswerteeinheit.

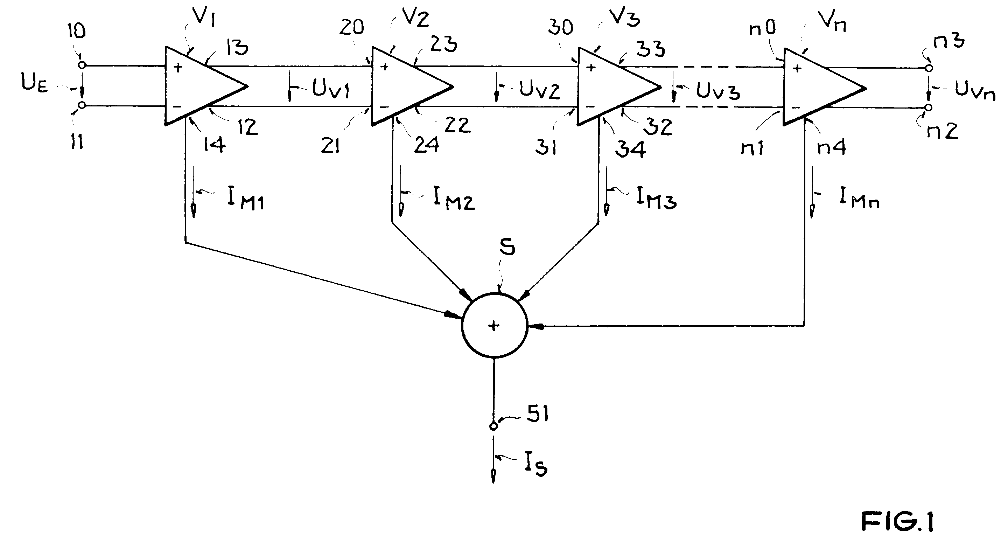

Gemäß der Figur 1 umfaßt die Schaltungsanordnung eine Verstärkerkette mit den hintereinander in Reihe geschalteten Verstärkerstufen V₁ ... Vₙ und die Summationseinheit S. Die Verstärkerstufen V₁ ... Vₙ sind alle als temperaturkompensierte Differenzverstärker mit jeweils gleichen und temperaturunabhängigen Verstärkungsfaktoren ausgeführt. Sie weisen jeweils zwei differentielle Eingangsanschlüsse 10 und 11 bzw. 20 und 21 bzw. 30 und 31 bzw. n0 und n1 als Verstärkereingang, jeweils zwei differentielle Ausgangsanschlüsse 12 und 13 bzw. 22 und 23 bzw. 32 und 33 bzw. n3 und n4 als Verstärkerausgang und jeweils einen Meßausgang 14 bzw. 24 bzw. 34 bzw. n4 auf. Die Eingangsanschlüsse 20, 21 bzw. 30, 31 bzw. n0, n1 der in der Verstärkerkette der ersten Verstärkerstufe V₁ folgenden Verstärkerstufen V₂, V₃ ... Vₙ sind dabei jeweils mit einem der Ausgangsanschlüsse 12, 13 bzw. 22, 23 bzw. 32, 33 der jeweils vorgeschalteten Verstärkerstufe V₁, V₂, V₃, ... verbunden.

Das Eingangssignal U_{E} wird den Eingangsanschlüssen 10 und 11 der ersten Verstärkerstufe V₁ als Eingangsspannung zugeführt. Diese wird durch die Verstärkerstufen V₁ ... Vₙ, sofern die Amplitude des Eingangssignal U_{E} so klein ist, daß keine der Verstärkerstufen V₁ ... Vₙ übersteuert, d. h. gesättigt wird, um das Produkt der verstärkungsfaktoren aller Verstärkerstufen V₁ ... Vₙ verstärkt. Bei zunehmender Amplitude des Eingangssignals U_{E} werden - beginnend mit der letzten Verstärkerstufe Vₙ - immer mehrere der Verstärkerstufen V₁ ... Vₙ übersteuert. Die an den Ausgangsanschlüssen n2, n3 der letzten Verstärkerstufe Vₙ anstehende Ausgangsspannung U_{Vn} ist dann begrenzt und somit verzerrt. Die Verstärkerstufen V₁ ... Vₙ liefern an ihren Meßausgängen 14 bzw. 24 bzw. 34 bzw. n4, welche alle mit der Summationseinheit S verbunden sind, jeweils einen Meßstrom I_{M1} bzw. ... I_{Mn} als Meßsignal, der der Aussteuerung der jeweiligen Verstärkerstufe V₁ ... Vₙ entspricht, d. h. der anzeigt, wie stark die jeweilige Verstärkerstufe V₁ ... Vₙ übersteuert oder gesättigt ist. Die Meßströme I_{M1} ... I_{Mn} werden der Summationseinheit S zugeführt, durch diese summiert und zur Mittelwertsbildung tiefpaßgefiltert. Die Summationseinheit S liefert dann einen Summationsstrom als Summensignal I_{S}, der um so größer ist, je mehrere der Verstärkerstufen V₁ ... Vₙ gesättigt sind und der demzufolge ein Maß der Amplitude des Eingangssignal U_{E} ist.

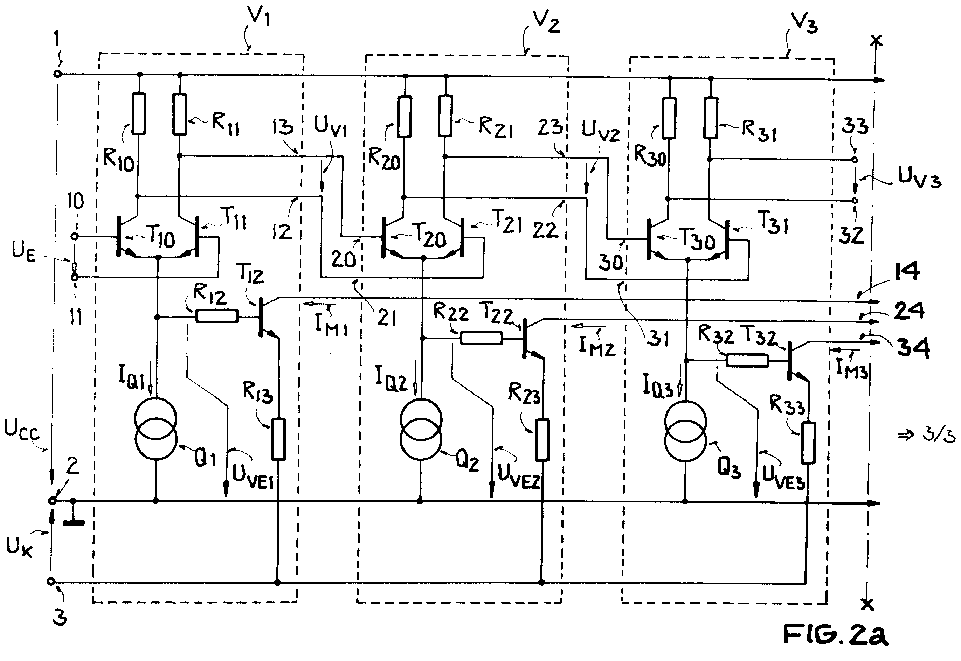

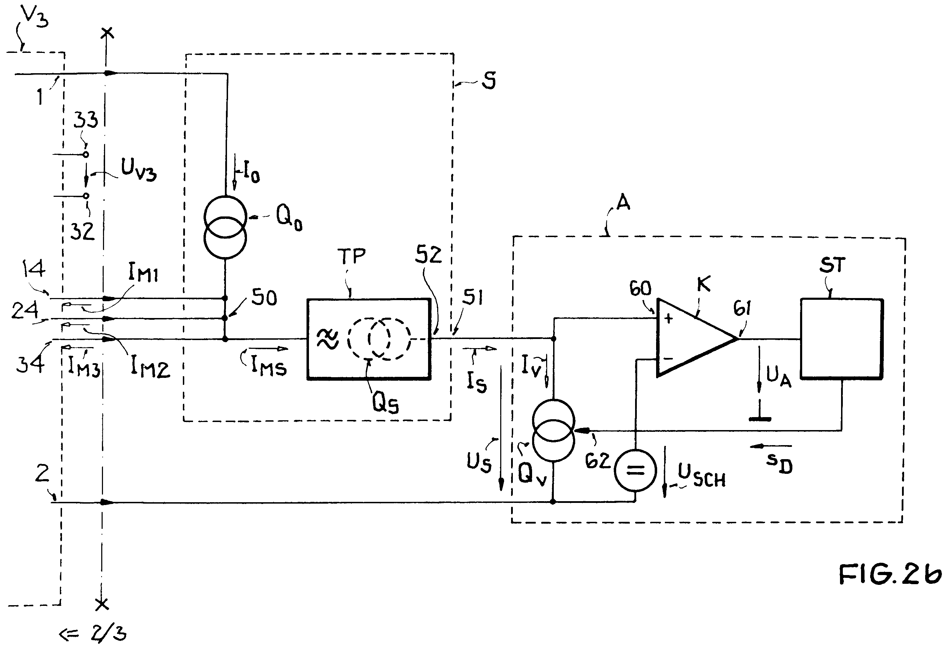

Gemäß Figur 2a, die eine Schaltungsanordnung mit drei Verstärkerstufen V₁, V₂, V₃ als Ausführungsbeispiel der Verstärkerkette aus Figur 1 zeigt, sind die Verstärkerstufen V₁, V₂, V₃ als Differenzverstärker mit jeweils zwei bipolaren Verstärkertransistoren T₁₀ und T₁₁ bzw. T₂₀ und T₂₁ bzw. T₃₀ und T₃₁, jeweils einer Emitterstromquelle Q₁ bzw. Q₂ bzw. Q₃, jeweils einer als Ausgangstransistor T₁₂ bzw. T₂₃ bzw. T₃₂ ausgeführten steuerbaren Ausgangsstromquelle und jeweils zwei Kollektorwiderständen R₁₀ und R₁₁ bzw. R₂₀ und R₂₁ bzw. R₃₀ und R₃₁ ausgebildet. Dabei sind die Basisanschlüsse der Verstärkertransistoren T₁₀ und T₁₁ bzw. T₂₀ und T₂₁ bzw. T₃₀ und T₃₁ mit jeweils einem der Eingangsanschlüsse 10 und 11 bzw. 20 und 21 bzw. 30 und 31 verbunden, die Kollektoranschlüsse der Verstärkertransistoren T₁₀ und T₁₁ bzw. T₂₀ und T₂₁ bzw. T₃₀ und T₃₁ mit jeweils einem der Ausgangsanschlüsse 12 und 13 bzw. 22 und 23 bzw. 32 und 33 verbunden, die Ausgangsanschlüsse 12 bzw. 13 bzw. 22 bzw. 23 bzw. 32 bzw. 33 über die Kollektorwiderstände R₁₀ bzw. R₁₁ bzw. R₂₀ bzw. R₂₁ bzw. R₃₀ bzw. R₃₁ mit dem ersten Versorgungsanschluß 1, an dem die Versorgungsspannung U_{CC} anliegt, verbunden, die Emitteranschlüsse der Verstärkertransistoren T₁₀ und T₁₁ bzw. T₂₀ und T₂₁ bzw. T₃₀ und T₃₁ mit dem Basisanschluß des Ausgangstransistors T₁₂ bzw. T₂₃ bzw. T₃₂ und über die Emitterstromquelle Q₁ bzw. Q₂ bzw. Q₃ mit dem zweiten Versorgungsanschluß 2, an dem ein Bezugspotential anliegt verbunden, die Kollektoranschlüsse der Ausgangstransistoren T₁₂ bzw. T₂₃ bzw. T₃₂ jeweils mit dem Meßausgang 14 bzw. 24 bzw. 34 verbunden und die Emitteranschlüsse der Ausgangstransistoren T₁₂ bzw. T₂₃ bzw. T₃₂ jeweils mit dem dritten Versorgungsanschluß 3, an dem eine Gleichspannung U_{K} zur Einstellung des Arbeitspunktes der Ausgangstransistoren T₁₂, T₂₂, T₃₂ ansteht, verbunden. Hierbei sind die Emitteranschlüsse der Vetttärkertransistoren T₁₀ und T₁₁ bzw. T₂₀ und T₂₁ bzw. T₃₀ und T₃₁ vorteilhafterweise über die Basiswiderstände R₁₂ bzw. R₂₂ bzw. R₃₂ an die Basisanschlüsse der Ausgangstransistoren T₁₂ bzw. T₂₃ bzw. T₃₂ angeschlossen und die Emitteranschlüsse der Ausgangstransistoren T₁₂, T₂₂, T₃₂ über jeweils einen der Emitterwiderstände R₁₃ bzw. R₁₄ bzw. R₁₅ an den dritten Versorgungsanschluß 3 angeschlossen.

Die Emitterstromquellen Q₁, Q₂, Q₃ sind jeweils als Bipolartransistor oder als Feldeffektransistor, beispielsweise als MOS-Transistor, ausgebildet, die derart angesteuert werden, daß sie jeweils einen zur Temperatur der Verstärkerstufen V₁, V₂, V₃ proportionalen und zu einem vorgegebenen Referenzwiderstand umgekehrt proportionalen Querstrom I_{Q1} bzw. I_{Q2} bzw. I_{Q3} liefern. Folglich sind die Verstärkungsfaktoren der Verstärkerstufen V₁, V₂, V₃, da sie bekanntlich proportional zum jeweiligen Querstrom I_{Q1} bzw. I_{Q2} bzw. I_{Q3}, proportional zu den jeweiligen Kollektorwiderständen R₁₀, R₁₁ bzw. R₂₀, R₂₁ bzw. R₃₀, R₃₁ und umgekehrt proportional zur Temperatur der Verstärkertransistoren T₁₀, T₁₁ bzw. T₂₁, T₂₂ bzw. T₃₁, T₃₂ und somit umgekehrt proportional zur Temperatur der Verstärkerstufen V₁ bzw. V₂ bzw. V₃ sind, temperaturunabhängig. Die durch die Meßausgänge 14 bzw. 24 bzw. 34 fließenden Meßströme I_{M1} bzw. I_{M2} bzw. I_{M3} werden durch die Emitterspannungen U_{VE1} bzw. U_{VE2} bzw. U_{VE2} der jeweiligen Verstärkertransistoren T₁₀, T₁₁ bzw. T₂₀, T₂₁ bzw. T₃₀, T₃₁ gesteuert. Diese Emitterspannungen U_{VE1} bzw. U_{VE2} bzw. U_{VE2} weisen jeweils einen Gleichanteil und jeweils einen aus dem wechselanteil der der jeweiligen Verstärkerstufe V₁ bzw. V₂ bzw. V₃ zugeführten Spannung U_{E} bzw. U_{V1} bzw. U_{V2} durch Gleichrichtung gebildeten gleichgerichteten Anteil auf. Die Meßströme I_{M1} bzw. I_{M2} bzw. I_{M3} setzen sich daher jeweils aus einem Ruheanteil und einem Aussteuerungsanteil zusammen. Die Ruheanteile sind dabei diejenigen Anteile der Meßströme I_{M1} bzw. I_{M2} bzw. I_{M3}, die dann fließen, wenn die Amplitude des Eingangssignals U_{E} 0 V beträgt. Die Aussteuerungsanteile sind von der Aussteuerung der jeweiligen Verstärkerstufe V₁ bzw. V₂ bzw. V₃, d. h. von der Amplitude der der jeweiligen Verstärkerstufe V₁ bzw. V₂ bzw. V₃ zugeführten Spannung U_{E} bzw. U_{V1} bzw. U_{V2} abhängig und sie sind bei übersteuerten Verstärkerstufen V₁, V₂, V₃ jeweils auf einen maximalen wert begrenzt. Eine Verstärkerstufe V₁ bzw. V₂ bzw. V₃ ist dabei dann übersteuert, wenn einer ihrer Verstärkertransistoren T₁₀, T₁₁ bzw. T₂₀, T₂₁ bzw. T₃₀, T₃₁ im wesentlichen den gesamten Ouerstrom I_{Q1} bzw. I_{Q2} bzw. I_{Q3} der jeweiligen Emitterstromquelle Q₁ bzw. Q₂ bzw. Q₃ führt, d. h. dann, wenn die ihren Eingangsanschlüssen 10, 11 bzw. 20, 21 bzw. 30, 31 zugeführte Spannung U_{E} bzw. U_{V1} bzw. U_{V2} die Aussteuergrenze der Verstärkerstufe V₁ bzw. V₂ bzw. V₃ überschreitet. Da die Verstärkungsfaktoren der Verstärkerstufen V₁, V₂, V₃ temperaturunabhängig sind, sind auch die von den Verstärkerstufen V₁, V₂, V₃ gelieferten Spannungen U_{V1}, U_{V2}, U_{V3} temperaturunabhängig, so daß bei gleicher Amplitude des Eingangssignals U_{E} immer die gleiche Anzahl der verstärkerstufen V₁, V₂, V₃ übersteuert sind. Der maximale wert der Meßströme I_{M1}, I_{M2}, I_{M3} ist hingegen von der Temperatur in etwa linear abhängig. Ursache dieser Temperaturabhängigkeit sind die von den Querströmen I_{Q1} bzw. I_{Q2} bzw. I_{Q3} abhängigen, an den Emitteranschlüssen der Verstärkertransistoren T₁₀, T₁₁ bzw. T₂₀, T₂₁ bzw. T₃₀, T₃₁ anstehenden Emitterspannungen U_{VE1} bzw. U_{VE2} bzw. U_{VE3}, durch die die Ausgangstransistoren T₁₂ bzw. T₂₂ bzw. T₃₂ gesteuert werden.

Gemäß Figur 2b, die ein Ausführungsbeispiel der Summationseinheit S aus Figur 1 und eine Auswerteeinheit A als Ausführungsbeispiel einer Schaltungsanordnung zur Auswertung des Summensignals I_{S} zeigt, weist die Summationseinheit S einen mit den Meßausgängen 14, 24, 34 der Verstärkerstufen V₁ bzw. V₂ bzw. V₃ verbundenen Summationsknoten 50, eine Ruhestromquelle Q₀, über die der Summationsknoten 50 mit dem ersten Versorgungsanschluß 1 verbunden ist, und ein Tiefpaßfilter TP, über das der Summationsknoten 50 mit dem Summationsausgang 51 der Summationseinheit S verbunden ist, auf. Der Ausgang 52 des Tiefpaßfilters TP ist als Stromausgang ausgebildet, d. h. das Tiefpaßfilter TP weist eine Ausgangsstromquelle Q_{S} zur Auskopplung des Summationsstroms I_{S} auf.

Die Auswerteeinheit A umfaßt die steuerbare Vergleichsstromquelle Q_{V}, die Vergleichseinheit K und die Steuereinheit ST. Die Vergleichsstromquelle Q_{V} ist mit dem Summationsausgang 51 und mit dem Eingang 60 der Vergleichseinheit K verbunden. Der Vergleichsstrom I_{V} der Vergleichsstromquelle Q_{V} kann durch ein von der Steuereinheit ST geliefertes digitales Steuersignal S_{D} zwischen verschiedenen zur Temperatur der Verstärkerstufen V₁, V₂, V₃ proportionalen und zum vorgegebenen Referenzwiderstand umgekehrt proportionalen Stromwerten umgeschaltet werden. Die Vergleichsstromquelle Q_{V} wirkt demnach als Digital-Analog-Wandler, der aus dem digitalen Steuersignal S_{D} einen analogen Strom - den Vergleichsstrom I_{V} - mit gleichem Temperaturkoeffizienten wie der Summationsstrom I_{S} erzeugt. Sie weist zur Steuerung des Vergleichsstromes I_{V} einen über die Steuereinheit ST mit dem Ausgang 61 der Vergleichsstufe K verbundenen Steuereingang 62 auf, dem das digitale Steuersignal S_{D} zugeführt wird.

Die Vergleichsstromquelle Q_{V} der Auswerteeinheit A und die Ausgangsstromquelle Q_{S} des Tiefpaßfilters TP sind als bipolare Transistoren oder als Feldeffekttransistoren, beispielsweise als MOS-Transistoren, ausgebildet.

Die Meßströme I_{M1}, I_{M2}, I_{M3} werden am Summationsknoten 50 summiert, wobei ihre Ruheanteile durch einen von der Ruhestromquelle Q₀ gelieferten Ruhestrom I₀ kompensiert werden. Dem Tiefpaßfilter TP wird daher lediglich ein aus den Aussteuerungsanteilen der Meßströme I_{M1}, I_{M2}, I_{M3} zusammengesetzter Summenmeßstrom I_{MS} zugeführt, welcher vom Eingangssignal U_{E} herrührende Frequenzanteile aufweist. Das Tiefpaßfilter TP erzeugt aus dem Summenmeßstrom I_{MS} durch Unterdrückung der vom Eingangssignal U_{E} stammenden Frequenzanteile den Summationsstrom I_{S}, der aufgrund seiner Abhängigkeit von den Meßströmen I_{M1}, I_{M2}, I_{M3} proportional zur Temperatur der Verstärkerstufen V₁, V₂, V₃ ist.

Am Summationsausgang 51 stellt sich aufgrund der gleichen Temperaturabhängigkeit des Summationsstroms I_{S} und des Vergleichsstroms I_{V} eine temperaturunabhängige Spannung U_{S} ein, die, je nachdem ob der Summationsstrom I_{S} größer oder kleiner als der Vergleichsstrom I_{V} ist, größer bzw. kleiner als eine Schwellenspannung U_{SCH} ist. Am Ausgang 61 der Vergleichsstufe K steht daher ein temperaturunabhängiges Auswertungssignal U_{A} an, das dem Vorzeichen der Differenz aus Vergleichsstrom I_{V} und Summationsstrom I_{S} entspricht. Die Vergleichsstromquelle Q_{V} wird durch die Steuereinheit ST derart gesteuert, daß der Vergleichsstrom I_{V} dem Summationsstrom I_{S} nachgeführt wird. Das digitale Steuersignal S_{D} wird hierzu variiert, wobei die Steuereinheit ST anhand des Auswertungssignals U_{A} erkennt in welche Richtung die Variation des digitale Steuersignal S_{D} erfolgen muß. Wegen der Temperaturunabhängigkeit des Auswertungssignals U_{A} ist auch das digitale Steuersignal S_{D} temperaturunabhängig, so daß die Amplitude des Eingangssignals U_{E} dem digitalen Steuersignal S_{D} entspricht, d. h. einem dem digitalen Steuersignal S_{D} entsprechenden Wert zugeordnet werden kann.

Die Vergleichsstufe K ist im vorliegenden Beispiel als Komparator ausgebildet, der die Spannung U_{S} mit der Schwellenspannung U_{SCH} vergleicht. Er kann jedoch auch als Inverter ausgebildet sein, der bei der Schwellenspannung U_{SCH}, die etwa gleich der halben Versorgungsspannung U_{CC} ist, umgeschaltet wird.

## Patentansprüche

1. Schaltungsanordnung zur Bildung eines der Amplitude eines Eingangssignals (U_{E}) entsprechenden Ausgangssignals (I_{S}), dadurch gekennzeichnet,
- daß eine Verstärkerkette aus mehreren in Reihe geschalteten temperaturkompensierten Verstärkerstufen (V₁ ... Vₙ) zur Verstärkung des Eingangssignals (U_{E}) vorgesehen ist, wobei die Verstärkerstufen (V₁ ... Vₙ) jeweils einen Meßausgang (14, 24, 34, n4) aufweisen, an dem ein der Aussteuerung der jeweiligen Verstärkerstufe (V₁ ... Vₙ) entsprechendes Meßsignal (I_{M1} ... I_{Mn}) ansteht, und
- daß eine mit den Meßausgängen (14, 24, 34, n4) der Verstärkerstufen (V₁ ... Vₙ) verbundene Summationseinheit (S) zur Bildung eines Summensignals (I_{S}) durch Summation der Meßsignale (I_{M1} ... I_{Mn}) vorgesehen ist, wobei das Summensignal (I_{S}) im wesentlichen durch die Anzahl der übersteuerten Verstärkerstufen (V₁ ... Vₙ) bestimmt ist und an einem Summationsausgang (51) der Summationseinheit (S) als Ausgangssignal (I_{S}) ansteht.

2. Schaltungsanordnung nach Anspruch 1, dadurch gekennzeichnet, daß die Verstärkerstufen (V₁ ... Vₙ) jeweils gleiche Verstärkungsfaktoren aufweisen.

3. Schaltungsanordnung nach Anspruch 1 oder 2, dadurch gekennzeichnet, daß jede der Verstärkerstufen (V₁, V₂, V₃) zwei bipolare Verstärkertransistoren (T₁₀, T₁₁, T₂₀, T₂₁, T₃₀, T₃₁), eine Emitterstromquelle (Q₁, Q₂, Q₃) zur Erzeugung eines zur Temperatur der Verstärkerstufen (V₁, V₂, V₃) proportionalen Querstromes (I_{Q1}, I_{Q2}, I_{Q3}) und eine steuerbare Ausgangsstromquelle (T₁₂, T₂₂, T₃₂) zur Erzeugung des Meßsignals (I_{M1}, I_{M2}, I_{M3}) der jeweiligen Verstärkerstufe (V₁, V₂, V₃) aufweist, wobei die Basisanschlüsse der Verstärkertransistoren (T₁₀, T₁₁, T₂₀, T₂₁, T₃₀, T₃₁) mit jeweils einem von zwei differentiellen Eingangsanschlüssen (10, 11, 20, 21, 30, 31) der jeweiligen Verstärkerstufe (V₁, V₂, V₃) verbunden sind, die Emitteranschlüsse der Verstärkertransistoren (T₁₀, T₁₁, T₂₀, T₂₁, T₃₀, T₃₁) mit der Emitterstromquelle (Q₁, Q₂, Q₃) und mit einem Steuereingang der Ausgangsstromquelle (T₁₂, T₂₂, T₃₂) verbunden sind, die Kollektoranschlüsse der Verstärkertransistoren (T₁₀, T₁₁, T₂₀, T₂₁, T₃₀, T₃₁) mit jeweils einem von zwei differentiellen Ausgangsanschlüssen (12, 13, 22, 23, 32, 33) der jeweiligen Verstärkerstufe (V₁, V₂, V₃) verbunden sind und ein Stromquellenausgang der Ausgangsstromquelle (T₁₂, T₂₂, T₃₂) mit dem Meßausgang (14, 24, 34) der jeweiligen Verstärkerstufe (V₁, V₂, V₃) verbunden ist.

4. Schaltungsanordnung nach Anspruch 3, dadurch gekennzeichnet, daß die Ausgangsstromquellen (T₁₂, T₂₂, T₃₂) der Verstärkerstufen (V₁, V₂, V₃) jeweils als bipolarer Ausgangstransistor ausgebildet sind und jeweils einen zur Temperatur der Verstärkerstufen (V₁, V₂, V₃) proportionalen Meßstrom als Meßsignal (I_{M1}, I_{M2}, I_{M3}) liefern.

5. Schaltungsanordnung nach einem der Ansprüche 1 bis 4, dadurch gekennzeichnet, daß die Summationseinheit (S) einen mit den Meßausgängen (14, 24, 34) der Verstärkerstufen (V₁, V₂, V₃) verbundenen Summationsknoten (50), einen Summationsausgang (51) und ein Tiefpaßfilter (TP) aufweist, wobei der Summationsknoten (50) über das Tiefpaßfilter (TP) mit dem Summationsausgang (51) verbunden ist und am Summationsausgang (51) ein Summationsstrom als Summensignal (I_{S}) ansteht.

6. Schaltungsanordnung nach Anspruch 5 dadurch gekennzeichnet, daß die Summationseinheit (S) eine mit dem Summationsknoten (50) verbundene Ruhestromquelle (Q₀) zur Kompensation von Ruheanteilen aus den Meßsignalen (I_{M1}, I_{M2}, I_{M3}) aufweist.

7. Schaltungsanordnung nach einem der vorherigen Ansprüche, dadurch gekennzeichnet, daß eine mit dem Summationsausgang (51) der Summationseinheit (S) verbundene Auswerteeinheit (A) zur Auswertung des Summensignals (I_{S}) vorgesehen ist.

8. Schaltungsanordnung nach Anspruch 7, dadurch gekennzeichnet, daß die Auswerteeinheit (A) eine mit dem Summationsausgang (51) der Summationseinheit (S) verbundene Vergleichsstromquelle (Q_{V}) zur Erzeugung eines zur Temperatur der Verstärkerstufen (V₁, V₂, V₃) proportionalen Vergleichsstromes (I_{V}) und eine mit dem Summationsausgang (51) verbundene Vergleichsstufe (K) zur Erzeugung eines dem Vorzeichen der Differenz aus Vergleichsstrom (I_{V}) und Summationsstrom (I_{S}) entsprechenden Auswertungssignals (U_{A}) aufweist.

9. Schaltungsanordnung nach Anspruch 8, dadurch gekennzeichnet, daß die Vergleichsstufe (K) als Inverter ausgebildet ist.

10. Schaltungsanordnung nach Anspruch 8 oder 9, dadurch gekennzeichnet, daß die Auswerteeinheit (A) eine durch das Auswertungssignal (U_{A}) ansteuerbare Steuereinheit (ST) zur Erzeugung eines digitalen Steuersignals (S_{D}) aufweist, daß die Vergleichsstromquelle (Q_{V}) einen Steuereingang (62) für das digitale Steuersignal (S_{D}) aufweist, wobei der Vergleichsstrom (I_{V}) durch das digitale Steuersignal (S_{D}) zwischen verschiedenen zur Temperatur der verstärkerstufen (V₁, V₂, V₃) proportionalen Stromwerten umschaltbar ist, und daß der Vergleichsstrom (I_{V}) mittels der Steuereinheit (ST) durch Variation des digitalen Steuersignals (S_{D}) dem Summationsstrom (I_{S}) nachführbar ist, so daß das digitale Steuersignal (S_{D}) der Amplitude des Eingangssignals (U_{E}) entspricht und von der Temperatur der Verstärkerstufen (V₁, V₂, V₃) unabhängig ist.
